# EUROPEAN PATENT APPLICATION

(11) **EP 4 083 159 A1**
(43) Date of publication of application: **02.11.2022**
(21) Application number: 20908299.9
(22) Date of filing: 15.12.2020
(51) Int. Cl.: C09J 201/00, C09J 11/08, C09J 183/04, C09J 183/05, C09J 183/07, H01L 21/02, H01L 21/304, H01L 21/683

(54) **ADHESIVE COMPOSITION, LAMINATE AND METHOD FOR PRODUCING SAME, METHOD FOR PEELING LAMINATE, AND METHOD FOR PROCESSING SEMICONDUCTOR-FORMING SUBSTRATE**

(30) Priority: 23.12.2019 JP 2019231633
(71) Applicant: Nissan Chemical Corporation, Tokyo 103-6119 (JP)
(72) Inventor: OGATA, Hiroto, Toyama-shi, Toyama 939-2792 (JP); SHINJO, Tetsuya, Toyama-shi, Toyama 939-2792 (JP); OGINO, Hiroshi, Toyama-shi, Toyama 939-2792 (JP); MORIYA, Shunsuke, Toyama-shi, Toyama 939-2792 (JP); OKUNO, Takahisa, Toyama-shi, Toyama 939-2792 (JP); FUKUDA, Takuya, Toyama-shi, Toyama 939-2792 (JP); YANAI, Masaki, Toyama-shi, Toyama 939-2792 (JP)
(74) Representative: Hoffmann Eitle
(86) International application number: PCT/JP2020/046836
(87) International publication number: WO 2021/131925

(57) **Abstract**

The invention provides an adhesive composition containing an adhesive component (S) and a release component (H) formed of a polyorganosiloxane having a complex viscosity of 3,400 (Pa·S) or higher.

## Description

### Technical Field

The present invention relates to an adhesive composition, to a laminate and a production method therefor, to a method for debonding a laminate, and to a method for processing a semiconductor-forming substrate (i.e., a substrate for forming a semiconductor element).

### Background Art

Conventionally, electronic elements and wires are 2-dimensionally (within a plane) integrated on a semiconductor wafer. In a trend toward further integration, demand has arisen for a semiconductor integration technique which achieves 3-dimensional integration (i.e., stacking) in addition to 2-dimensional integration. In the technique of 3-dimensional integration, a number of layers are stacked with wire connection by the mediation of through silicon vias (TSVs). In integration of multiple layers, each component wafer to be stacked is thinned by polishing (i.e., grinding) a surface opposite the circuit-furnished surface (i.e., a back surface), and the thus-thinned semiconductor wafers are stacked.

Before thinning, the semiconductor wafer (may also be called simply "wafer") is fixed to a support for facilitating polishing by means of a polishing machine (i.e., grinder). Since the fixation must be easily removed after polishing, the fixation is called temporary bonding. Temporary bonding must be easily removed from the support. When such temporary bonding is removed by excessive force, in some cases a thinned semiconductor wafer may be broken or deformed. In order to prevent such a phenomenon, the temporarily bonded support is detached in a gentle manner. However, from another aspect, it is not preferred that the temporarily bonded support be removed or slid by a stress applied during polishing of the back surface of the semiconductor wafer. Therefore, temporary bonding must withstand the stress during polishing and must be easily removed after polishing.

For example, one required performance includes having high stress (i.e., strong adhesion) within the plane direction during polishing and low stress (i.e., weak adhesion) toward the thickness direction during detaching.

Meanwhile, a semiconductor wafer is electrically connected to semiconductor chips by the mediation of, for example, bumps formed of a metallic conductive material. By use of such chips having bumps, the dimension of a semiconductor package product is reduced.

Under such circumstances, there has been reported an adhesive composition containing a specific polysiloxane (see, for example, Patent Document 1). Thus, the present inventors previously re-examined the reported adhesive composition. The results showed that when an adhesive layer formed from the adhesive composition was peeled from a substrate having bumps, an adhesive residue remained on the substrate under certain debonding conditions. In addition, there is still room for improvement in storage stability of the adhesive composition.

### Prior Art Documents

### Patent Documents

Patent Document 1: WO 2017/221772

### Summary of the Invention

### Problems to be Solved by the Invention

The present invention has been conceived under such circumstances. Thus, an object of the present invention is to provide an adhesive composition which exhibits excellent storage stability, and which provides a thin film suitably serving as an adhesive layer which can be suitably debonded with a reduce amount of residue of the layer after debonding, even when the adhesive layer has been formed on a substrate having bumps. Another object of the present invention is to provide a laminate and a production method therefor. Still another object is to provide a method for debonding a laminate. Yet another object is to provide a method for processing a semiconductor-forming substrate.

### Means for Solving the Problems

The present inventors have conducted extensive studies for solving the aforementioned problems, and as a result have found that the problems can be solved by providing an adhesive composition containing an adhesive component (S) and a release component (i.e., a component for facilitating peeling or removal of adhesion) (H) containing a polyorganosiloxane having a complex viscosity of 3,400 (Pa·s) or more. The present invention has been accomplished on the basis of this finding.

Accordingly, the present invention provides the following.
1. An adhesive composition comprising an adhesive component (S) and a release component (H) formed of a polyorganosiloxane having a complex viscosity of 3,400 (Pa·S) or higher.
2. An adhesive composition according to 1 above, wherein the polyorganosiloxane includes at least one species selected from the group consisting of an epoxy-group-containing polyorganosiloxane, a methyl-group-containing polyorganosiloxane, and a phenyl-group-containing polyorganosiloxane.
3. An adhesive composition according to 2 above, wherein the polyorganosiloxane includes a methyl-group-containing polyorganosiloxane.
4. An adhesive composition according to any of 1 to 3 above, wherein the polyorganosiloxane has a complex viscosity of 30,000 (Pa·S) or lower.
5. An adhesive composition according to any of 1 to 3 above, wherein the polyorganosiloxane has a complex viscosity of 4,000 to 25,000 (Pa·S).
6. An adhesive composition according to any of 1 to 5 above, wherein the adhesive component (S) contains a component (A) which is cured through hydrosilylation.
7. An adhesive composition according to 6 above, wherein the component (A) which is cured through hydrosilylation comprises a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and
   the polysiloxane (A1) comprises a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and a polyorganosiloxane (a2) having one or more units selected from the group consisting of a siloxane unit represented by SiO₂ (unit Q"), a siloxane unit represented by R^{1"}R^{2"}R^{3"} SiO_{1/2} (unit M"), a siloxane unit represented by R^{4"}R^{5"}SiO_{2/2} (unit D"), and a siloxane unit represented by R^{6"}SiO_{3/2} (unit T"), and at least one unit selected from the group consisting of unit M", unit D", and unit T" (wherein each of R^{1"} to R^{6"} is a group or an atom bonded to a silicon atom and represents an alkyl group or a hydrogen atom, and at least one of R^{1"} to R^{6"} is a hydrogen atom).
8. A laminate comprising a first substrate formed of a semiconductor-forming substrate, a second substrate formed of a support substrate, and an adhesive layer which binds the first substrate to the second substrate in a peelable manner,
   wherein the adhesive layer is a film formed from an adhesive composition as recited in any of 1 to 7 above.
9. A method for producing a laminate, the method comprising a step of applying an adhesive composition as recited in any of 1 to 7 above onto a first substrate formed of a semiconductor-forming substrate or a second substrate formed of a support substrate, to thereby form an adhesive coating layer; and
   a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.
10. A method for debonding a laminate, the method comprising a step of applying an adhesive composition as recited in any of 1 to 7 above onto a first substrate formed of a semiconductor-forming substrate or a second substrate formed of a support substrate, to thereby form an adhesive coating layer;
   a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment, to thereby produce a laminate; and
   a second step of debonding the laminate at the interface between the first substrate and the adhesive layer.
11. A method for processing a semiconductor-forming substrate, the method comprising
   a step of applying an adhesive composition as recited in any of 1 to 7 above onto a first substrate formed of a semiconductor-forming substrate or a second substrate formed of a support substrate, to thereby form an adhesive coating layer;
   a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment, to thereby produce a laminate; and
   a step of processing the first substrate of the laminate.

### Effects of the Invention

Since the adhesive composition of the present invention contains a polyorganosiloxane as a release component, the adhesive composition can provide an adhesive layer which can be suitably debonded. Also, the polyorganosiloxane has a complex viscosity of 3,400 (Pa·s) or more. Thus, even when the adhesive layer is formed on a substrate having bumps, the amount of residue of the layer is reduced after debonding of the adhesive layer. In addition, deposition of the adhesive component in the adhesive composition is prevented, as is deposition of a mixture of the adhesive component and release component in the adhesive composition. No clear reason has been elucidated for why such a complex viscosity contributes to a reduction in the amount of residue and prevention of deposition of the adhesive component and a mixture of the adhesive and release components. However, one presumed reason for this is as follows: the polyorganosiloxane serving as the release component has a very high complex viscosity, which prevents undesirable mixing of the release component with the adhesive component in the composition and in the adhesive layer, thereby preventing generation of insoluble matter in the composition and resulting in suitable delocalization of the release component in the adhesive layer.

Therefore, when the adhesive composition of the present invention is used, an adhesive layer that can be debonded without application of an excessive load for debonding can be formed on a support or a workpiece (e.g., a wafer) at high reproducibility. Furthermore, the amount of residue can be reduced on the support or the workpiece after debonding of the adhesive layer. Thus, production of a more reliable semiconductor device is expected.

The adhesive composition of the present invention exhibits improved storage stability. Therefore, for example, the adhesive composition can be produced and stored in a larger amount than ever before, and accordingly efficient use can be made of a production facility for the composition. Thus, it is expected to reduce the production cost of the adhesive composition itself and the cost of a semiconductor device produced from the composition.

### Modes for Carrying Out the Invention

The present invention will next be described in more detail.

The adhesive composition of the present invention contains an adhesive component (S).

The adhesive component (S) may be any compound used as an adhesive component in such a type of composition, so long as it has bonding property. Examples of the compound include a siloxane resin, a hydrocarbon resin, an acrylic styrene resin, a maleimide resin, and any combination of these. Among these, a siloxane resin is preferred.

In one preferred embodiment of the present invention, the adhesive composition of the present invention contains, as the adhesive component (S), a component (A) that is cured through hydrosilylation.

In a more preferred embodiment of the present invention, the component (A) which is cured through hydrosilylation contains, for example, a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2); wherein the polysiloxane (A1) contains a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T', and a polyorganosiloxane (a2) having one or more units selected from the group consisting of a siloxane unit represented by SiO₂ (unit Q^{"}), a siloxane unit represented by R^{1"}R^{2"}R^{3"}SiO_{1/2} (unit M"), a siloxane unit represented by R^{4"}R^{5"}SiO_{2/2} (unit D''), and a siloxane unit represented by R^{6"}SiO_{3/2} (unit T"), and at least one unit selected from the group consisting of unit M", unit D", and unit T".

Each of R¹ to R⁶ is a group or an atom bonded to a silicon atom and represents an alkyl group, an alkenyl group, or a hydrogen atom.

Each of R^{1'} to R^{6'} is a group bonded to a silicon atom and represents an alkyl group or an alkenyl group, and at least one of R^{1'} to R^{6'} is an alkenyl group.

Each of R^{1"} to R^{6"} is a group or an atom bonded to a silicon atom and represents an alkyl group or a hydrogen atom, and at least one of R^{1"} to R^{6"} is a hydrogen atom.

The alkyl group may be linear-chain, branched-chain, or cyclic. No particular limitation is imposed on the number of carbon atoms thereof, and the number of carbon atoms is preferably 40 or less, more preferably 30 or less, still more preferably 20 or less, yet more preferably 10 or less.

Specific examples of the linear-chain or branched-chain alkyl group include, but are not limited to, methyl, ethyl, n-propyl, i-propyl, n-butyl, i-butyl, s-butyl, t-butyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, and 1-ethyl-2-methyl-n-propyl.

Of these, methyl is preferred.

Specific examples of the cycloalkyl group include, but are not limited to, cycloalkyl groups such as cyclopropyl, cyclobutyl, 1-methyl-cyclopropyl, 2-methyl-cyclopropyl, cyclopentyl, 1-methyl-cyclobutyl, 2-methyl-cyclobutyl, 3-methyl-cyclobutyl, 1,2-dimethyl-cyclopropyl, 2,3-dimethyl-cyclopropyl, 1-ethyl-cyclopropyl, 2-ethyl-cyclopropyl, cyclohexyl, 1-methyl-cyclopentyl, 2-methyl-cyclopentyl, 3-methyl-cyclopentyl, 1-ethyl-cyclobutyl, 2-ethyl-cyclobutyl, 3-ethyl-cyclobutyl, 1,2-dimethyl-cyclobutyl, 1,3-dimethyl-cyclobutyl, 2,2-dimethyl-cyclobutyl, 2,3-dimethyl-cyclobutyl, 2,4-dimethyl-cyclobutyl, 3,3-dimethyl-cyclobutyl, 1-n-propyl-cyclopropyl, 2-n-propyl-cyclopropyl, 1-i-propyl-cyclopropyl, 2-i-propyl-cyclopropyl, 1,2,2-trimethyl-cyclopropyl, 1,2,3-trimethyl-cyclopropyl, 2,2,3-trimethyl-cyclopropyl, 1-ethyl-2-methyl-cyclopropyl, 2-ethyl-1-methyl-cyclopropyl, 2-ethyl-2-methyl-cyclopropyl, and 2-ethyl-3-methyl-cyclopropyl; and bicycloalkyl groups such as bicyclobutyl, bicyclopentyl, bicyclohexyl, bicycloheptyl, bicyclooctyl, bicyclononyl, and bicyclodecyl.

The alkenyl group may be linear-chain or branched-chain. No particular limitation is imposed on the number of carbon atoms thereof, and the number of carbon atoms is preferably 40 or less, more preferably 30 or less, still more preferably 20 or less.

Specific examples of the alkenyl group include, but are not limited to, ethenyl, 1-propenyl, 2-propenyl, 1-methyl-1-ethenyl, 1-butenyl, 2-butenyl, 3-butenyl, 2-methyl-1-propenyl, 2-methyl-2-propenyl, 1-ethylethenyl, 1-methyl-1-propenyl, 1-methyl-2-propenyl, 1-pentenyl, 2-pentenyl, 3-pentenyl, 4-pentenyl, 1-n-propylethenyl, 1-methyl-1-butenyl, 1-methyl-2-butenyl, 1-methyl-3-butenyl, 2-ethyl-2-propenyl, 2-methyl-1-butenyl, 2-methyl-2-butenyl, 2-methyl-3-butenyl, 3-methyl-1-butenyl, 3-methyl-2-butenyl, 3-methyl-3-butenyl, 1,1-dimethyl-2-propenyl, 1-i-propylethenyl, 1,2-dimethyl-1-propenyl, 1,2-dimethyl-2-propenyl, 1-cyclopentenyl, 2-cyclopentenyl, 3-cyclopentenyl, 1-hexenyl, 2-hexenyl, 3-hexenyl, 4-hexenyl, 5-hexenyl, 1-methyl-1-pentenyl, 1-methyl-2-pentenyl, 1-methyl-3-pentenyl, 1-methyl-4-pentenyl, 1-n-butylethenyl, 2-methyl-1-pentenyl, 2-methyl-2-pentenyl, 2-methyl-3-pentenyl, 2-methyl-4-pentenyl, 2-n-propyl-2-propenyl, 3-methyl-1-pentenyl, 3-methyl-2-pentenyl, 3-methyl-3-pentenyl, 3-methyl-4-pentenyl, 3-ethyl-3-butenyl, 4-methyl-1-pentenyl, 4-methyl-2-pentenyl, 4-methyl-3-pentenyl, 4-methyl-4-pentenyl, 1,1-dimethyl-2-butenyl, 1,1-dimethyl-3-butenyl, 1,2-dimethyl-1-butenyl, 1,2-dimethyl-2-butenyl, 1,2-dimethyl-3-butenyl, 1-methyl-2-ethyl-2-propenyl, 1-s-butylethenyl, 1,3-dimethyl-1-butenyl, 1,3-dimethyl-2-butenyl, 1,3-dimethyl-3-butenyl, 1-i-butylethenyl, 2,2-dimethyl-3-butenyl, 2,3-dimethyl-1-butenyl, 2,3-dimethyl-2-butenyl, 2,3-dimethyl-3-butenyl, 2-i-propyl-2-propenyl, 3,3-dimethyl-1-butenyl, 1-ethyl-1-butenyl, 1-ethyl-2-butenyl, 1-ethyl-3-butenyl, 1-n-propyl-1-propenyl, 1-n-propyl-2-propenyl, 2-ethyl-1-butenyl, 2-ethyl-2-butenyl, 2-ethyl-3-butenyl, 1,1,2-trimethyl-2-propenyl, 1-t-butylethenyl, 1-methyl-1-ethyl-2-propenyl, 1-ethyl-2-methyl-1-propenyl, 1-ethyl-2-methyl-2-propenyl, 1-i-propyl-1-propenyl, 1-i-propyl-2-propenyl, 1-methyl-2-cyclopentenyl, 1-methyl-3-cyclopentenyl, 2-methyl-1-cyclopentenyl, 2-methyl-2-cyclopentenyl, 2-methyl-3-cyclopentenyl, 2-methyl-4-cyclopentenyl, 2-methyl-5-cyclopentenyl, 2-methylene-cyclopentyl, 3-methyl-1-cyclopentenyl, 3-methyl-2-cyclopentenyl, 3-methyl-3-cyclopentenyl, 3-methyl-4-cyclopentenyl, 3-methyl-5-cyclopentenyl, 3-methylene-cyclopentyl, 1-cyclohexenyl, 2-cyclohexenyl, and 3-cyclohexenyl.

Of these, ethenyl and 2-propenyl are preferred.

As described above, the polysiloxane (A1) includes the polyorganosiloxane (a1) and the polyorganosiloxane (a2). In curing, the alkenyl group present in the polyorganosiloxane (a1) and the hydrogen atom (Si-H group) present in the polyorganosiloxane (a2) form a cross-linking structure through hydrosilylation in the presence of the platinum group metal catalyst (A2).

The polyorganosiloxane (a1) has one or more units selected from the group consisting of unit Q', unit M', unit D', and unit T', and at least one unit selected from the group consisting of unit M', unit D', and unit T'. Two or more polyorganosiloxanes satisfying the above conditions may be used in combination as the polyorganosiloxane (a1).

Examples of preferred combinations of two or more units selected from the group consisting of unit Q', unit M', unit D', and unit T' include, but are not limited to, (unit Q' and unit M'), (unit D' and unit M'), (unit T' and unit M'), and (unit Q', unit T', and unit M').

In the case where the polyorganosiloxane (a1) includes two or more polyorganosiloxanes, examples of preferred combinations include, but are not limited to, (unit Q' and unit M') + (unit D' and unit M'); (unit T' and unit M') + (unit D' and unit M'); and (unit Q', unit T', and unit M') + (unit T' and unit M').

The polyorganosiloxane (a2) has one or more units selected from the group consisting of unit Q" unit M", unit D", and unit T", and at least one unit selected from the group consisting of unit M", unit D", and unit T". Two or more polyorganosiloxanes satisfying the above conditions may be used in combination as the polyorganosiloxane (a2).

Examples of preferred combinations of two or more units selected from the group consisting of unit Q" unit M", unit D", and unit T" include, but are not limited to, (unit M" and unit D"), (unit Q" and unit M"), and (unit Q", unit T", and unit M").

The polyorganosiloxane (a1) is formed of siloxane units in which an alkyl group and/or an alkenyl group is bonded to a silicon atom. The alkenyl group content of the entire substituents R^{1'} to R^{6'} is preferably 0.1 mol% to 50.0 mol%, more preferably 0.5 mol% to 30.0 mol%, and the remaining R^{1'} to R^{6'} may be alkyl groups.

The polyorganosiloxane (a2) is formed of siloxane units in which an alkyl group and/or a hydrogen atom is bonded to a silicon atom. The hydrogen atom content of the entire substituents or atoms R^{1"} to R^{6"} is preferably 0.1 mol% to 50.0 mol%, more preferably 10.0 mol% to 40.0 mol%, and the remaining R^{1"} to R^{6"} may be alkyl groups.

The polysiloxane (A1) includes the polyorganosiloxane (a1) and the polyorganosiloxane (a2). In one preferred embodiment of the present invention, the ratio by mole of alkenyl groups present in the polyorganosiloxane (a1) to hydrogen atoms forming Si-H bonds present in the polyorganosiloxane (a2) is 1.0:0.5 to 1.0:0.66.

The weight average molecular weight of each of the polyorganosiloxane (a1) and the polyorganosiloxane (a2) is generally 500 to 1,000,000. From the viewpoint of attaining the effects of the present invention at high reproducibility, the weight average molecular weight is preferably 5,000 to 50,000.

Meanwhile, in the present invention, the weight average molecular weight, number average molecular weight, and polydispersity may be determined by means of, for example, a GPC apparatus (EcoSEC, HLC-8320GPC, products of Tosoh Corporation) and GPC columns (TSKgel SuperMultiporeHZ-N and TSKgel SuperMultiporeHZ-H, products of Tosoh Corporation) at a column temperature of 40°C and a flow rate of 0.35 mL/min by use of tetrahydrofuran as an eluent (extraction solvent) and polystyrene (product of Sigma-Aldrich) as a standard substance.

The viscosity of each of the polyorganosiloxane (a1) and the polyorganosiloxane (a2) is generally 10 to 1,000,000 (mP·s). From the viewpoint of attaining the effects of the present invention at high reproducibility, the viscosity is preferably 50 to 10,000 (mP·s). Notably, in the present invention, the viscosity of is measured at 25°C by means of an E-type rotational viscometer.

The polyorganosiloxane (a1) and the polyorganosiloxane (a2) react with each other via hydrosilylation, to thereby form a cured film. Thus, the curing mechanism differs from the mechanism of curing mediated by, for example, silanol groups. Therefore, neither of the siloxanes is required to have a silanol group or a functional group forming a silanol group through hydrolysis (e.g., an alkyloxy group).

In one preferred embodiment of the present invention, the adhesive component (S) contains the aforementioned polysiloxane (A1) and the platinum group metal catalyst (A2).

The platinum-based metallic catalyst is used to accelerate hydrosilylation between alkenyl groups of the polyorganosiloxane (a1) and Si-H groups of the polyorganosiloxane (a2).

Specific examples of the platinum-based metallic catalyst include, but are not limited to, platinum catalysts such as platinum black, platinum(II) chloride, chloroplatinic acid, a reaction product of chloroplatinic acid and a monohydric alcohol, a chloroplatinic acid-olefin complex, and platinum bis(acetoacetate).

Examples of the platinum-olefin complex include, but are not limited to, a complex of platinum with divinyltetramethyldisiloxane.

The amount of platinum group metal catalyst (A2) is generally 1.0 to 50.0 ppm, with respect to the total amount of polyorganosiloxane (a1) and polyorganosiloxane (a2).

In order to suppress progress of hydrosilylation, the component (A) may contain a polymerization inhibitor (A3).

No particular limitation is imposed on the polymerization inhibitor, so long as it can suppress the progress of hydrosilylation. Specific examples of the polymerization inhibitor include alkynyl alcohols such as 1-ethynyl-1-cyclohexanol and 1,1-diphenyl-2-propyn-1-ol.

Generally, the amount of polymerization inhibitor with respect to the total amount of the polyorganosiloxane (a1) and the polyorganosiloxane (a2) is 1,000.0 ppm or more from the viewpoint of attaining the effect, and 10,000.0 ppm or less from the viewpoint of preventing excessive suppression of hydrosilylation.

The adhesive composition of the present invention contains a release component (H) containing a polyorganosiloxane having a complex viscosity of 3,400 (Pa·s) or more. In the present invention, the complex viscosity of the polyorganosiloxane serving as the release component (H) corresponds to a value as measured at 25°C by means of a rheometer. The complex viscosity may be measured by means of, for example, Rheometer MCR-302 (product of Anton Paar).

Examples of preferred polyorganosiloxanes (i.e., release component (H)) include, but are not limited to, an epoxy-group-containing polyorganosiloxane, a methyl-group-containing polyorganosiloxane, and a phenyl-group-containing polyorganosiloxane.

Thus, the polyorganosiloxane having a complex viscosity of 3,400 (Pa·s) or more (i.e., the release component (H)) preferably includes at least one species selected from the group consisting of an epoxy-group-containing polyorganosiloxane, a methyl-group-containing polyorganosiloxane, and a phenyl-group-containing polyorganosiloxane, and more preferably includes a methyl-group-containing polyorganosiloxane. Most preferably, the adhesive composition of the present invention includes, as the release component (H), only a methyl-group-containing polyorganosiloxane having a complex viscosity of 3,400 (Pa·s) or more.

As described above, the polyorganosiloxane as the release component (H) has a complex viscosity of 3,400 (Pa·s) or more. From the viewpoint of attaining the effects of the present invention at high reproducibility, the complex viscosity is preferably 4,000 (Pa·s) or more, more preferably 4,500 (Pa·s) or more, still more preferably 5,000 (Pa·s) or more, much more preferably 5,500 (Pa·s) or more. In the case where an organic solvent is used for preparation of the adhesive composition, the complex viscosity is generally 30,000 (Pa·s) or less, preferably 25,000 (Pa·s) or less, more preferably 20,000 (Pa·s) or less, still more preferably 15,000 (Pa·s) or less, much more preferably 10,000 (Pa·s) or less, from the viewpoint of securing the solubility of the component in the organic solvent.

The polyorganosiloxane as the release component (H) generally has a weight average molecular weight of 100,000 to 2,000,000. The weight average molecular weight is preferably 200,000 to 1,200,000, more preferably 300,000 to 900,000, from the viewpoint of attaining the effects of the present invention at high reproducibility. The polyorganosiloxane generally has a dispersity of 1.0 to 10.0. The dispersity is preferably 1.5 to 5.0, more preferably 2.0 to 3.0, from the viewpoint of attaining the effects of the present invention at high reproducibility. The weight average molecular weight and the dispersity may be measured through the methods as described above.

The epoxy-group-containing polyorganosiloxane includes such a siloxane containing a siloxane unit represented by, for example, R¹¹R¹²SiO_{2/2} (unit D¹⁰).

R¹¹ is a group bonded to a silicon atom and represents an alkyl group, and R¹² is a group bonded to a silicon atom and represents an epoxy group or an organic group containing an epoxy group. Specific examples of the alkyl group include those as exemplified above.

The epoxy group in the organic group containing an epoxy group may be an independent epoxy group which does not condense with another ring structure, or may be an epoxy group forming a condensed ring with another ring structure (e.g., a 1,2-epoxycyclohexyl group).

Specific examples of the organic group containing an epoxy group include, but are not limited to, 3-glycidoxypropyl and 2-(3,4-epoxycyclohexyl)ethyl.

In the present invention, examples of preferred epoxy-group-containing polyorganosiloxanes include, but are not limited to, epoxy-modified polydimethylsiloxane.

The epoxy-group-containing polyorganosiloxane contains the aforementioned siloxane unit (unit D¹⁰), but may also contain the aforementioned unit Q, unit M and/or unit T, in addition to unit D¹⁰.

In one preferred embodiment of the present invention, specific examples of the epoxy-group-containing polyorganosiloxane include polyorganosiloxane formed only of unit D¹⁰, polyorganosiloxane formed of unit D¹⁰ and unit Q, polyorganosiloxane formed of unit D¹⁰ and unit M, polyorganosiloxane formed of unit D¹⁰ and unit T, polyorganosiloxane formed of unit D¹⁰, unit Q, and unit M, polyorganosiloxane formed of unit D¹⁰, unit M, and unit T, and polyorganosiloxane formed of unit D¹⁰, unit Q, unit M, and unit T.

The epoxy-group-containing polyorganosiloxane is preferably an epoxy-group-containing polydimethylsiloxane having an epoxy value of 0.1 to 5. The weight average molecular weight thereof is generally 1,500 to 500,000, but preferably 100,000 or lower, for the purpose of suppression of precipitation in the adhesive.

Specific examples of the epoxy-group-containing polyorganosiloxane include, but are not limited to, those represented by formulas (E1) to (E3): 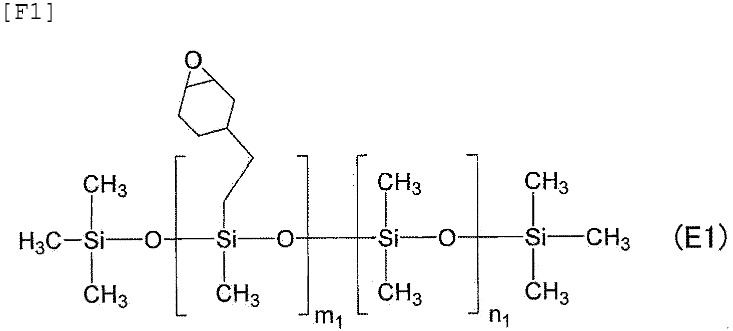 (wherein each of m₁ and n₁ represents the number of repeating units and is a positive integer); 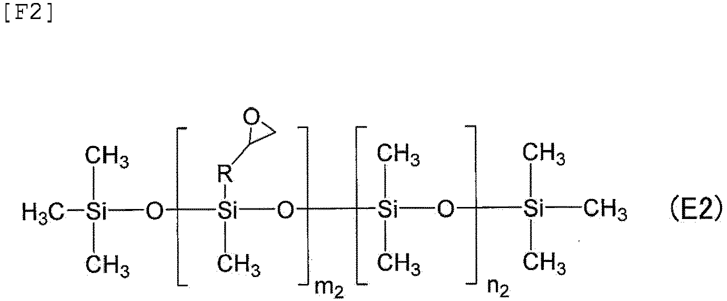 (wherein each of m₂ and n₂ represents the number of repeating units and is a positive integer, and R represents a C1 to C10 alkylene group); and 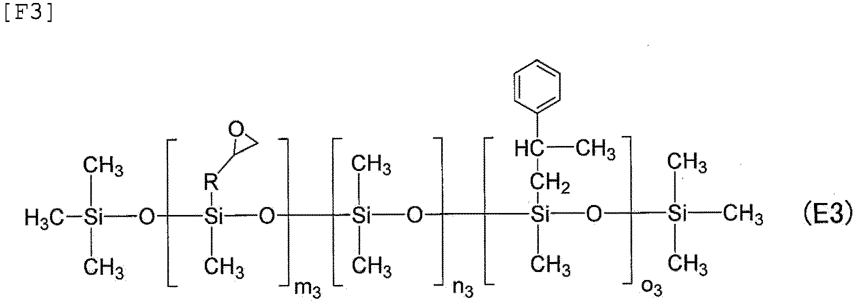 (wherein each of m₃, n₃ and o₃ represents the number of repeating units and is a positive integer, and R represents a C1 to C10 alkylene group).

The methyl-group-containing polyorganosiloxane includes, for example, a siloxane containing a siloxane unit represented by R²¹⁰R²²⁰SiO_{2/2} (unit D²⁰⁰), preferably a siloxane containing a siloxane unit represented by R²¹R²¹SiO_{2/2} (unit D²⁰).

Each of R²¹⁰ and R²²⁰ is a group bonded to a silicon atom and represents an alkyl group. At least one of R²¹⁰ and R²²⁰ is a methyl group. Specific examples of the alkyl group include those as exemplified above.

R²¹ is a group bonded to a silicon atom and represents an alkyl group. Specific examples of the alkyl group include those as exemplified above. R²¹ is preferably a methyl group.

In the present invention, examples of preferred methyl-group-containing polyorganosiloxanes include, but are not limited to, polydimethylsiloxane.

The methyl-group-containing polyorganosiloxane contains the aforementioned siloxane unit (unit D²⁰⁰ or unit D²⁰), but may also contain the aforementioned unit Q, unit M and/or unit T, in addition to unit D²⁰⁰ or unit D²⁰.

In one embodiment of the present invention, specific examples of the methyl-group-containing polyorganosiloxane include polyorganosiloxane formed only of unit D²⁰⁰, polyorganosiloxane formed of unit D²⁰⁰ and unit Q, polyorganosiloxane formed of unit D²⁰⁰ and unit M, polyorganosiloxane formed of unit D²⁰⁰ and unit T, polyorganosiloxane formed of unit D²⁰⁰, unit Q, and unit M, polyorganosiloxane formed of unit D²⁰⁰, unit M, and unit T, and polyorganosiloxane formed of unit D²⁰⁰, unit Q, unit M, and unit T.

In one preferred embodiment of the present invention, specific examples of the methyl-group-containing polyorganosiloxane include polyorganosiloxane formed only of unit D²⁰, polyorganosiloxane formed of unit D²⁰ and unit Q, polyorganosiloxane formed of unit D²⁰ and unit M, polyorganosiloxane formed of unit D²⁰ and unit T, polyorganosiloxane formed of unit D²⁰, unit Q, and unit M, polyorganosiloxane formed of unit D²⁰, unit M, and unit T, and polyorganosiloxane formed of unit D²⁰, unit Q, unit M, and unit T.

Specific examples of the methyl-group-containing polyorganosiloxane include, but are not limited to, a polyorganosiloxane represented by formula (M1): 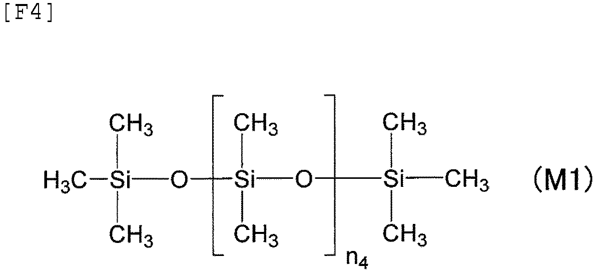 (wherein n₄ represents the number of repeating units and is a positive integer).

Examples of the phenyl-group-containing polyorganosiloxane include a siloxane containing a siloxane unit represented by R³¹R³²SiO_{2/2} (unit D³⁰).

R³¹ is a group bonded to a silicon atom and represents a phenyl group or an alkyl group, and R³² is a group bonded to a silicon atom and represents a phenyl group. Specific examples of the alkyl group include those as exemplified above. R³¹ is preferably a methyl group.

The phenyl-group-containing polyorganosiloxane contains the aforementioned siloxane unit (unit D³⁰), but may also contain the aforementioned unit Q, unit M and/or unit T, in addition to unit D³⁰.

In one preferred embodiment of the present invention, specific examples of the phenyl-group-containing polyorganosiloxane include polyorganosiloxane formed only of unit D³⁰, polyorganosiloxane formed of unit D³⁰ and unit Q, polyorganosiloxane formed of unit D³⁰ and unit M, polyorganosiloxane formed of unit D³⁰ and unit T, polyorganosiloxane formed of unit D³⁰, unit Q, and unit M, polyorganosiloxane formed of unit D³⁰, unit M, and unit T, and polyorganosiloxane formed of unit D³⁰, unit Q, unit M, and unit T.

Specific examples of the methyl-group-containing polyorganosiloxane include, but are not limited to, a polyorganosiloxane represented by formula (P1) or (P2): 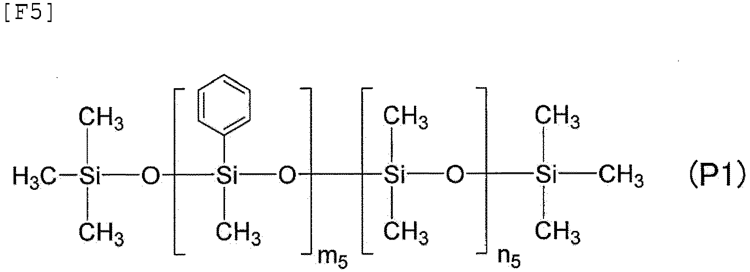 (wherein each of m₅ and n₅ represents the number of repeating units and is a positive integer); or 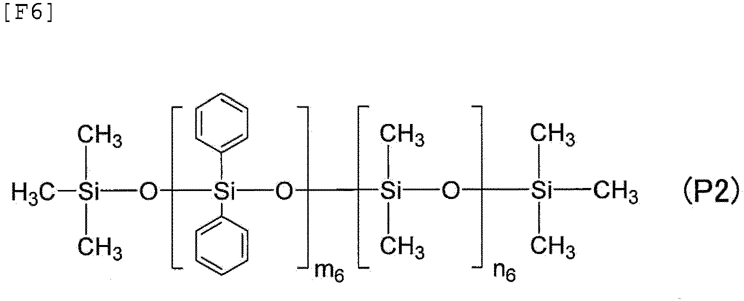 (wherein each of m₆ and n₆ represents the number of repeating units and is a positive integer).

The ratio by mass of adhesive component (S) to release component (H) [(S):(H)] is generally 5:95 to 95:5, preferably 50:50 to 93:7, more preferably 60:40 to 91:9, still more preferably 65:35 to 89:11, yet more preferably 70:30 to 87:13, further preferably 75:25 to 85:15.

For the purpose of adjusting the viscosity or for other reasons, the adhesive composition of the present invention may contain a solvent. Specific examples of the solvent include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. These solvents may be used singly or in combination of two or more species.

In the case where the adhesive composition of the present invention contains a solvent, the solvent content is appropriately adjusted in consideration of a target viscosity thereof, the application method to be employed, the thickness of the formed thin film, etc. The solvent content of the entire adhesive composition is generally about 10 to about 90 mass%.

The adhesive composition of the present invention may be produced by mixing the adhesive component (S), the release component (H), and an optionally used solvent.

No particular limitation is imposed on the sequential order of mixing, so long as the adhesive composition of the present invention can be easily produced at high reproducibility. One possible example of the production method includes dissolving the adhesive component (S) and the release component (H) in a solvent. Another possible example of the production method includes dissolving a part of the adhesive component (S) and the release component (H) in a solvent, dissolving the remaining components in another solvent, and mixing the two thus-obtained solutions. However, the production method is not limited to the above examples. Notably, so long as the relevant components are not decomposed or denatured in preparation of the adhesive composition, the mixture may be appropriately heated.

In the present invention, in order to remove foreign substances present in the adhesive composition, the composition may be filtered through a sub-micrometer filter or the like in the course of production of the composition or after mixing all the components.

The laminate of the present invention has a first substrate formed of a semiconductor-forming substrate, a second substrate formed of a support substrate, and an adhesive layer which binds the first substrate to the second substrate in a peelable manner, wherein the adhesive layer is a film formed from the aforementioned adhesive composition. In this regard, no particular limitation is imposed on the laminate of the present invention, so long as the laminate has an adhesive layer which binds the two substrates together in a peelable manner, and the adhesive layer is a film formed from the aforementioned adhesive composition. Thus, for example, any layer having a specific function may be disposed between a substrate and the adhesive layer for reducing the load applied on the substrate during debonding or other reasons. The function layer is appropriately selected, so long as the effects of the present invention are not impaired.

In one preferred mode of the present invention, the laminate of the present invention has a first substrate formed of a semiconductor-forming substrate, a second substrate formed of a support substrate, and an adhesive layer which is a film formed from the aforementioned adhesive composition such that the film is in contact with the two substrates.

In one preferred mode of the present invention, the laminate production method of the present invention includes a step of applying the aforementioned adhesive composition onto a first or second substrate, to thereby form an adhesive coating layer, and a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment. Through this post-heat treatment, the adhesive coating layer forms a suitable adhesive layer. Particularly when the adhesive composition contains a component which is cured through hydrosilylation, curing is accelerated, to thereby from a suitable adhesive layer.

In one embodiment, the first substrate is a wafer, and the second substrate is a support. The adhesive composition may be applied to either of the first or second substrate, or both of the first and second substrates. Preferably, the adhesive composition is applied to the first substrate.

No particular limitation is imposed on the wafer. Examples of the wafer include, but are not limited to, a silicon wafer or a glass wafer having a diameter of about 300 mm and a thickness of about 770 µm.

The semiconductor-forming substrate such as a silicon wafer may have bumps (e.g., ball bumps, printed bumps, stud bumps, and plating bumps). Generally, such bumps are provided under conditions appropriately selected from a bump height of about 1 to about 200 µm, a bump diameter of 1 µm to 200 µm, and a bump pitch of 1 µm to 500 µm.

Specific examples of the plating bump include, but are not limited to, an Sn-base plating bump such as an Sn-Ag bump, an Sn bump, or an Au-Sn bump.

No particular limitation is imposed on the support (carrier). Examples of the support include, but are not limited to, a silicon wafer having a diameter of about 300 mm and a thickness of about 700 µm.

In the case where debonding is performed through laser light radiation from the second substrate side, a substrate which allows passage of the laser light is used as the second substrate. The transmittance of the second substrate is generally ≥80%, preferably ≥90%. Specific examples of the second substrate include, but are not limited to, a glass wafer having a diameter of about 300 mm and a thickness of about 700 µm.

As used herein, the term "laser light" refers to laser light employed in the below-mentioned debonding step. The wavelength of the laser light is generally 190 nm to 600 nm, typically 308 nm, 343 nm, 355 nm, or 532 nm.

The thickness of the aforementioned adhesive coating layer is generally 5 to 500 µm. However, the thickness is preferably 10 µm or greater, more preferably 20 µm or greater, still more preferably 30 µm or greater, from the viewpoint of maintaining the film strength, and it is preferably 200 µm or less, more preferably 150 µm or less, still more preferably 120 µm or less, yet more preferably 70 µm or less, from the viewpoint of avoiding variation in uniformity of the film thickness.

No particular limitation is imposed on the application method, and spin coating is generally employed. In one alternative application method of the present invention, a coating film is formed through spin coating or a similar technique, and the sheet-form coating film is attached. However, in the present invention, application of the adhesive composition directly onto a substrate is more preferred than the above attaching technique.

The heating temperature is generally 80°C to 150°C. The time of heating is generally 30 seconds or longer, preferably 1 minute or longer, for securing bonding performance. Also, the heating time is generally 10 minutes or shorter, preferably 5 minutes or shorter, from the viewpoint of suppressing deterioration of the adhesive layer and other members.

In the reduced pressure treatment, the two substrates and the adhesive coating layer disposed therebetween are placed in an atmosphere at 10 Pa to 10,000 Pa. The time of the reduced pressure treatment is generally 1 to 30 minutes.

In one preferred embodiment of the present invention, the two substrates and the layer disposed therebetween are bonded together preferably through a heat treatment, more preferably through a heat treatment in combination with a reduced pressure treatment.

No particular limitation is imposed on the load which is applied to the first and second substrates in a thickness direction, so long as the first and second substrates, and the layer disposed therebetween are not damaged, and these elements are closely adhered. The load is generally 10 to 1,000 N.

The temperature of post-heating is preferably 120°C or higher from the viewpoint, for example, attaining sufficient curing rate, and preferably 260°C or lower from the viewpoint of preventing deterioration of the substrates and the adhesives due to excessive heating. The heating time is generally 1 minute or longer from the viewpoint of suitable joining of a wafer through curing of an adhesive component, preferably 5 minutes or longer. Also, the heating time is generally 180 minutes or shorter, preferably 120 minutes or shorter, from the viewpoint of avoiding, for example, an adverse effect on the adhesive layers due to excessive heating. Heating may be performed by means of a hot plate, an oven, or the like. Notably, one purpose of performing post-heating is to attain more suitably curing when the component (A) contains a component which is cured through hydrosilylation.

The laminate debonding method employed in the present invention is not particularly limited. Examples of the debonding method include debonding with solvent, debonding with laser light, mechanical debonding by means of a machine member having a sharp part, and manual peeling between a support and a wafer. Generally, debonding is performed after production of the laminate of the present invention and a certain subsequent processing and the like.

One example of the processing applied to the laminate of the present invention is processing of a back surface of the first substrate formed of a semiconductor-forming substrate, the surface being opposite the circuit-furnished surface of the first substrate. Typically, the processing is thinning a wafer by polishing (grinding) the backside thereof. Thereafter, the thinned wafer is provided with through silicon vias (TSVs) and the like and then removed from the support. A plurality of such wafers are stacked to form a wafer laminate, to thereby complete 3-dimensional mounting. Before or after the above process, a backside electrode and the like are formed on the wafer. When thinning of a wafer and the TSV process are performed, a thermal load of 250 to 350°C is applied to the laminate bonded to the support. The laminate of the present invention including the adhesive layer has heat resistance to the load.

In one mode of thinning, the backside surface (a surface opposite the circuit-furnished surface) of a wafer having a diameter of about 300 mm and a thickness of about 770 µm is polished (ground), the thickness of the wafer can be reduced to about 10 µm to about 100 µm.

In one exemplary case, debonding of the laminate of the present invention is performed through specific force with respect to the adhesive layer disposed between the first and second substrates, the first and second substrates can be easily peeled from the adhesive layer. The force required for debonding is generally about 1 to about 50 N, preferably about 10 to about 30 N, from the viewpoint of, for example, avoiding damage of the substrates and the like.

When a residue of the adhesive layer remains on the surface of the wafer, the resin component of the residue can be removed through washing out (e.g., dissolution or lift-off) with a solvent, tape peeling, or the like.

The method of the present invention for processing a semiconductor-forming substrate is applied to the first substrate of the laminate produced through the aforementioned method.

### Examples

(1) Agitator A: Planetary Centrifugal Mixer ARE-500 (product of Thinky Corporation)
(2) Agitator B: Mix Rotor VMR-5R (product of AS ONE CORPORATION)
(3) Measurement of viscosity: Rotary Viscometer TVE-22H (product of Toki Sangyo Co., Ltd)
(4) Measurement of complex viscosity: Rheometer MCR-302 (product of Anton Paar)
(5) Vacuum bonding apparatus: Auto Bonder (product of Suss MicroTec)
(6) Debonding apparatus X: Manual Debonder (product of Suss MicroTec)
(7) Debonding apparatus Y: Auto Debonder (product of Suss MicroTec)
(8) Measurement of weight average molecular weight and dispersity: GPC apparatus (EcoSEC, HLC-8320GPC, product of TOSOH CORPORATION) and GPC columns (TSKgel SuperMultipore HZ-N, TSKgel SuperMultipore HZ-H, products of TOSOH CORPORATION) (column temperature: 40°C, eluent (elution solvent): tetrahydrofuran, flow rate (flow speed): 0.35 mL/minute, standard sample: polystyrene (product of Sigma-Aldrich))

### [1] Preparation of composition

### [Example 1-1]

A solution of vinyl-group-containing MQ resin (product of WACKER Chemie AG) in p-menthane (concentration: 80.6 mass%) (105.26 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (35.24 g) serving as release component (H), and p-menthane (product of Nippon Terpene Chemicals, Inc.) (54.11 g) and n-decane (product of SANKYO CHEMICAL Co., Ltd.) (8.35 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (16.97 g) serving as polyorganosiloxane (a2) and vinyl-group-containing linear-chain polydimethylsiloxane having a viscosity of 200 mPa·s (product of WACKER Chemie AG) (24.80 g) serving as polyorganosiloxane (a1). To the resultant mixture was added a portion (1.31 g) of a mixture separately prepared through agitation of 1,1-diphenyl-2-propyn-1-ol (product of Tokyo Chemical Industry Co., Ltd.) (1.63 g) and 1-ethynyl-1-cyclohexanol (product of WACKER Chemie AG) (1.63 g) serving as polymerization inhibitor (A3) and p-menthane (product of Nippon Terpene Chemicals, Inc.) (3.26 g) serving as a solvent by means of agitator B for 60 minutes. The resultant mixture was agitated by means of agitator A for 5 minutes.

To the resultant mixture was added a portion (3.97 g) of a mixture separately prepared through agitation of a platinum catalyst (product of WACKER Chemie AG) (0.26 g) serving as catalyst (A2) and vinyl-group-containing linear-chain polydimethylsiloxane having a viscosity of 1,000 mPa·s (product of WACKER Chemie AG) (19.58 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 3,900 mPa·s.

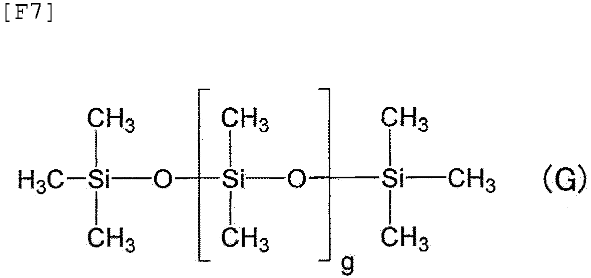

(In formula (G), g represents the number of repeating units and is a positive integer.)

### [Example 1-2]

A solution of vinyl-group-containing MQ resin (product of WACKER Chemie AG) in p-menthane (concentration: 80.6 mass%) (78.35 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (23.68 g) serving as release component (H), and p-menthane (product of Nippon Terpene Chemicals, Inc.) (29.74 g) and n-decane (product of SANKYO CHEMICAL Co., Ltd.) (5.05 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (13.68 g) serving as polyorganosiloxane (a2) and vinyl-group-containing linear-chain polydimethylsiloxane having a viscosity of 200 mPa·s (product of WACKER Chemie AG) (23.15 g) serving as polyorganosiloxane (a1). To the resultant mixture was added a portion (1.05 g) of a mixture separately prepared through agitation of 1,1-diphenyl-2-propyn-1-ol (product of Tokyo Chemical Industry Co., Ltd.) (0.53 g) and 1-ethynyl-1-cyclohexanol (product of WACKER Chemie AG) (0.53 g) serving as polymerization inhibitor (A3) and p-menthane (product of Nippon Terpene Chemicals, Inc.) (1.06 g) serving as a solvent by means of agitator B for 60 minutes. The resultant mixture was agitated by means of agitator A for 5 minutes.

To the resultant mixture was added a portion (5.29 g) of a mixture separately prepared through agitation of a platinum catalyst (product of WACKER Chemie AG) (0.063 g) serving as catalyst (A2) and vinyl-group-containing linear-chain polydimethylsiloxane having a viscosity of 1,000 mPa·s (product of WACKER Chemie AG) (10.52 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 3,900 mPa·s.

### [Example 1-3]

A solution of vinyl-group-containing MQ resin (product of WACKER Chemie AG) in p-menthane (concentration: 80.6 mass%) (95.80 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (21.38 g) serving as release component (H), and p-menthane (product of Nippon Terpene Chemicals, Inc.) (16.10 g) and n-decane (product of SANKYO CHEMICAL Co., Ltd.) (3.92 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (15.44 g) serving as polyorganosiloxane (a2) and vinyl-group-containing linear-chain polydimethylsiloxane having a viscosity of 200 mPa·s (product of WACKER Chemie AG) (22.57 g) serving as polyorganosiloxane (a1). To the resultant mixture was added a portion (1.05 g) of a mixture separately prepared through agitation of 1,1-diphenyl-2-propyn-1-ol (product of Tokyo Chemical Industry Co., Ltd.) (0.59 g) and 1-ethynyl-1-cyclohexanol (product of WACKER Chemie AG) (0.59 g) serving as polymerization inhibitor (A3) and p-menthane (product of Nippon Terpene Chemicals, Inc.) (1.19 g) serving as a solvent by means of agitator B for 60 minutes. The resultant mixture was agitated by means of agitator A for 5 minutes.

To the resultant mixture was added a portion (3.60 g) of a mixture separately prepared through agitation of a platinum catalyst (product of WACKER Chemie AG) (0.071 g) serving as catalyst (A2) and vinyl-group-containing linear-chain polydimethylsiloxane having a viscosity of 1,000 mPa·s (product of WACKER Chemie AG) (7.13 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 4,100 mPa·s.

### [Example 1-4]

A solution of vinyl-group-containing MQ resin (product of WACKER Chemie AG) in p-menthane (concentration: 80.6 mass%) (81.06 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (21.38 g) serving as release component (H), and p-menthane (product of Nippon Terpene Chemicals, Inc.) (18.96 g) and n-decane (product of SANKYO CHEMICAL Co., Ltd.) (3.92 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (15.44 g) serving as polyorganosiloxane (a2) and vinyl-group-containing linear-chain polydimethylsiloxane having a viscosity of 200 mPa·s (product of WACKER Chemie AG) (32.07 g) serving as polyorganosiloxane (a1). To the resultant mixture was added a portion (1.05 g) of a mixture separately prepared through agitation of 1,1-diphenyl-2-propyn-1-ol (product of Tokyo Chemical Industry Co., Ltd.) (0.59 g) and 1-ethynyl-1-cyclohexanol (product of WACKER Chemie AG) (0.59 g) serving as polymerization inhibitor (A3) and p-menthane (product of Nippon Terpene Chemicals, Inc.) (1.19 g) serving as a solvent by means of agitator B for 60 minutes. The resultant mixture was agitated by means of agitator A for 5 minutes.

To the resultant mixture was added a portion (5.98 g) of a mixture separately prepared through agitation of a platinum catalyst (product of WACKER Chemie AG) (0.071 g) serving as catalyst (A2) and vinyl-group-containing linear-chain polydimethylsiloxane having a viscosity of 1,000 mPa·s (product of WACKER Chemie AG) (11.88 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 3,800 mPa·s.

### [Example 1-5]

A solution of vinyl-group-containing MQ resin (product of WACKER Chemie AG) in p-menthane (concentration: 80.6 mass%) (62.24 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (13.68 g) serving as release component (H), and p-menthane (product of Nippon Terpene Chemicals, Inc.) (9.63 g) and n-decane (product of SANKYO CHEMICAL Co., Ltd.) (2.46 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (11.86 g) serving as polyorganosiloxane (a2) and vinyl-group-containing linear-chain polydimethylsiloxane having a viscosity of 200 mPa·s (product of WACKER Chemie AG) (24.63 g) serving as polyorganosiloxane (a1). To the resultant mixture was added a portion (0.91 g) of a mixture separately prepared through agitation of 1,1-diphenyl-2-propyn-1-ol (product of Tokyo Chemical Industry Co., Ltd.) (0.46 g) and 1-ethynyl-1-cyclohexanol (product of WACKER Chemie AG) (0.46 g) serving as polymerization inhibitor (A3) and p-menthane (product of Nippon Terpene Chemicals, Inc.) (0.91 g) serving as a solvent by means of agitator B for 60 minutes. The resultant mixture was agitated by means of agitator A for 5 minutes.

To the resultant mixture was added a portion (4.59 g) of a mixture separately prepared through agitation of a platinum catalyst (product of WACKER Chemie AG) (0.065 g) serving as catalyst (A2) and vinyl-group-containing linear-chain polydimethylsiloxane having a viscosity of 1,000 mPa·s (product of WACKER Chemie AG) (9.12 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 3,100 mPa·s.

### [Example 1-6]

A solution of vinyl-group-containing MQ resin (product of WACKER Chemie AG) in p-menthane (concentration: 80.6 mass%) (69.29 g) serving as polyorganosiloxane (a1), a polyorganosiloxane represented by formula (G) (complex viscosity: 6,000 Pa·s, weight average molecular weight: 642,000 (dispersity: 2.6), product of WACKER Chemie AG, trade name: GENIOPLAST GUM) (10.15 g) serving as release component (H), and p-menthane (product of Nippon Terpene Chemicals, Inc.) (2.04 g) and n-decane (product of SANKYO CHEMICAL Co., Ltd.) (1.78 g) serving as solvents were added to a 600-mL container dedicated for agitator A, and the mixture was agitated by means of agitator A for 5 minutes. The agitation was repeated a total of 8 times with a short break in the middle (agitation time: 40 minutes in total).

To the resultant mixture were added SiH-group-containing linear-chain polydimethylsiloxane having a viscosity of 100 mPa·s (product of WACKER Chemie AG) (13.20 g) serving as polyorganosiloxane (a2) and vinyl-group-containing linear-chain polydimethylsiloxane having a viscosity of 200 mPa·s (product of WACKER Chemie AG) (27.42 g) serving as polyorganosiloxane (a1). To the resultant mixture was added a portion (1.02 g) of a mixture separately prepared through agitation of 1,1-diphenyl-2-propyn-1-ol (product of Tokyo Chemical Industry Co., Ltd.) (0.51 g) and 1-ethynyl-1-cyclohexanol (product of WACKER Chemie AG) (0.51 g) serving as polymerization inhibitor (A3) and p-menthane (product of Nippon Terpene Chemicals, Inc.) (1.02 g) serving as a solvent by means of agitator B for 60 minutes. The resultant mixture was agitated by means of agitator A for 5 minutes.

To the resultant mixture was added a portion (5.11 g) of a mixture separately prepared through agitation of a platinum catalyst (product of WACKER Chemie AG) (0.061 g) serving as catalyst (A2) and vinyl-group-containing linear-chain polydimethylsiloxane having a viscosity of 1,000 mPa·s (product of WACKER Chemie AG) (10.15 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 2,100 mPa·s.

### [Comparative Example 1-1]

A solution of vinyl-group-containing MQ resin (product of WACKER Chemie AG) in p-menthane (concentration: 80.6 mass%) (104.14 g) serving as polyorganosiloxane (a1), a polyorganosiloxane represented by formula (A) (complex viscosity: 800 Pa·s) (58.11 g) serving as release component (H), and p-menthane (product of Nippon Terpene Chemicals, Inc.) (34.94 g) and n-decane (product of SANKYO CHEMICAL Co., Ltd.) (6.20 g) serving as solvents were added to a 600-mL container dedicated for agitator A, and the mixture was agitated by means of agitator A for 5 minutes.

To the resultant mixture were added SiH-group-containing linear-chain polydimethylsiloxane having a viscosity of 100 mPa·s (product of WACKER Chemie AG) (16.79 g) serving as polyorganosiloxane (a2) and vinyl-group-containing linear-chain polydimethylsiloxane having a viscosity of 200 mPa·s (product of WACKER Chemie AG) (24.54 g) serving as polyorganosiloxane (a1). To the resultant mixture was added a portion (1.29 g) of a mixture separately prepared through agitation of 1,1-diphenyl-2-propyn-1-ol (product of Tokyo Chemical Industry Co., Ltd.) (1.61 g) and 1-ethynyl-1-cyclohexanol (product of WACKER Chemie AG) (1.61 g) serving as polymerization inhibitor (A3) and p-menthane (product of Nippon Terpene Chemicals, Inc.) (3.23 g) serving as a solvent by means of agitator B for 60 minutes. The resultant mixture was agitated by means of agitator A for 5 minutes.

To the resultant mixture was added a portion (4.00 g) of a mixture separately prepared through agitation of a platinum catalyst (product of WACKER Chemie AG) (0.65 g) serving as catalyst (A2) and vinyl-group-containing linear-chain polydimethylsiloxane having a viscosity of 1,000 mPa·s (product of WACKER Chemie AG) (19.37 g) serving as polyorganosiloxane (a1) by means of agitator A for 5 minutes. The resultant mixture was agitated by means of agitator A for 5 minutes.

Eventually, the resultant mixture was filtered through a nylon filter (300 mesh), to thereby prepare an adhesive composition. The adhesive composition was found to have a viscosity of 3,000 mPa·s.

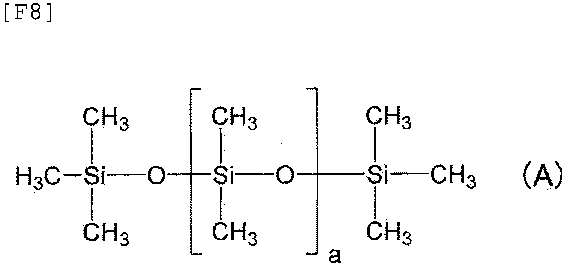

(In formula (A), a represents the number of repeating units and is a positive integer.)

### [2] Evaluation of bonding and debonding properties

### [Example 2-1]

The adhesive composition prepared in Example 1-1 was applied, through spin coating, to a 300-mm silicon wafer (thickness: 770 µm) serving as a device-side wafer, and heated at 120°C for 1.5 minutes (pre-thermal treatment), to thereby form an adhesive coating layer having a thickness of about 60 µm on a circuit surface of the wafer.

Thereafter, the silicon wafer having the adhesive coating layer was bonded to a 300-mm glass wafer (thickness: 700 µm) serving as a carrier-side wafer (support) so as to sandwich the adhesive coating layer between these wafers in a vacuum bonding apparatus. The resultant product was placed on a hot plate so that the device-side wafer was located downward, and heated at 200°C for 10 minutes (post-thermal treatment), to thereby produce a laminate. The bonding was performed at 23°C and a reduced pressure of 1,000 Pa under application of a load of 30 N.

### [Example 2-2]

The adhesive composition prepared in Example 1-2 was applied, through spin coating, to a 300-mm silicon wafer (thickness: 770 µm) serving as a device-side wafer, and heated at 120°C for 1.5 minutes (pre-thermal treatment), to thereby form an adhesive coating layer on a circuit surface of the wafer so that the thickness of an adhesive layer of a laminate to be produced was about 60 µm.

Thereafter, the silicon wafer having the adhesive coating layer was bonded to a 300-mm glass wafer (thickness: 700 µm) serving as a carrier-side wafer (support) so as to sandwich the adhesive coating layer between these wafers in a vacuum bonding apparatus. The resultant product was placed on a hot plate so that the device-side wafer was located downward, and heated at 200°C for 10 minutes (post-thermal treatment), to thereby produce a laminate. The bonding was performed at 23°C and a reduced pressure of 1,000 Pa under application of a load of 30 N.

### [Example 2-3]

The adhesive composition prepared in Example 1-3 was applied, through spin coating, to a 300-mm silicon wafer (thickness: 770 µm) serving as a device-side wafer, and heated at 120°C for 1.5 minutes (pre-thermal treatment), to thereby form an adhesive coating layer on a circuit surface of the wafer so that the thickness of an adhesive layer of a laminate to be produced was about 60 µm.

Thereafter, the silicon wafer having the adhesive coating layer was bonded to a 300-mm glass wafer (thickness: 700 µm) serving as a carrier-side wafer (support) so as to sandwich the adhesive coating layer between these wafers in a vacuum bonding apparatus. The resultant product was placed on a hot plate so that the device-side wafer was located downward, and heated at 200°C for 10 minutes (post-thermal treatment), to thereby produce a laminate. The bonding was performed at 23°C and a reduced pressure of 1,000 Pa under application of a load of 30 N.

In each of the laminates produced in Examples 2-1 to 2-3, the adhesive layer was evaluated for its bonding and debonding properties.

The bonding property was evaluated by determining the presence or absence of voids through visual observation from the glass wafer (support) side of the laminate. The bonding property was evaluated as "Good" when no voids were observed, whereas the bonding property was evaluated as "Poor" when voids were observed.

The debonding property was evaluated by measuring the force required for debonding of the adhesive layer. The debonding property was evaluated as "Good" when the adhesive layer was debonded by means of the debonding apparatus X, whereas the debonding property was evaluated as "Poor" when the adhesive layer was not debonded by means of the debonding apparatus X. The debonding was performed at a position between the device-side wafer and the adhesive layer. Table 1 shows the results.

In each of the laminates produced in Examples 2-1 to 2-3, no voids were observed, and suitable debonding was effected between the device-side wafer and the adhesive layer by application of a predetermined force.

**[Table 1]**

| | Debonding | Debonding force | Voids |
|---|---|---|---|
| Example 2-1 | Good | 15 N | Absence |
| Example 2-2 | Good | 24 N | Absence |
| Example 2-3 | Good | 22 N | Absence |

### [3] Observation of residue after debonding

### [Example 3-1]

The adhesive composition prepared in Example 1-1 was applied, through spin coating, to a PI TEG 300-mm wafer (thickness: 770 µm, bump diameter: 0.03 mm, bump height: 0.04 mm, bump pitch: 0.06 × 0.1 mm) serving as a device-side wafer, to thereby form an adhesive coating layer having a thickness of about 60 µm on a circuit surface of the wafer.

Thereafter, the wafer having the adhesive coating layer was bonded to a 300-mm silicon wafer (thickness: 770 µm) serving as a carrier-side wafer (support) so as to sandwich the adhesive coating layer between these wafers in a vacuum bonding apparatus. The resultant product was placed on a hot plate so that the device-side wafer was located downward, and heated at 200°C for 10 minutes (post-thermal treatment), to thereby produce a laminate. The bonding was performed at 23°C and a reduced pressure of 1,000 Pa under application of a load of 30 N.

### [Comparative Example 3-1]

A laminate was produced in the same manner as employed in Example 3-1, except that the adhesive composition prepared in Example 1-1 was replaced with the adhesive composition prepared in Comparative Example 1-1.

Each of the resultant laminates was debonded, and then the presence or absence of residue was determined. Specifically, the laminate was debonded by means of the debonding apparatus Y, and then the presence or absence of residue on the device-side wafer was determined. The debonding was performed at a position between the device-side wafer and the adhesive layer.

In the laminate of Example 3-1, no residue was observed on the device-side wafer after debonding of the adhesive layer. In contrast, in the laminate of Comparative Example 3-1, residue was observed on the device-side wafer after debonding of the adhesive layer.

The results indicated that, in the case of the adhesive composition of the present invention, even when an adhesive layer is formed on a substrate having bumps, the amount of residue is reduced after debonding of the adhesive layer.

### [4] Storage stability test of adhesive composition

The adhesive compositions prepared in Examples 1-1 to 1-6 and Comparative Example 1-1 were stored in a storage chamber set at -20°C for one month. Consequently, neither turbidity nor deposition was observed in the adhesive compositions prepared in Examples 1-1 to 1-6 after the storage. In contrast, turbidity and precipitation were observed in the adhesive composition prepared in Comparative Example 1-1 after the storage.

The test has revealed that the adhesive composition of the present invention exhibits storage stability superior to that of a conventional adhesive composition.

## Claims

1. An adhesive composition comprising an adhesive component (S) and a release component (H) formed of a polyorganosiloxane having a complex viscosity of 3,400 (Pa·S) or higher.

2. An adhesive composition according to claim 1,
wherein the polyorganosiloxane includes at least one species selected from the group consisting of an epoxy-group-containing polyorganosiloxane, a methyl-group-containing polyorganosiloxane, and a phenyl-group-containing polyorganosiloxane.

3. An adhesive composition according to claim 2,
wherein the polyorganosiloxane includes a methyl-group-containing polyorganosiloxane.

4. An adhesive composition according to any one of claims 1 to 3, wherein the polyorganosiloxane has a complex viscosity of 30,000 (Pa·S) or lower.

5. An adhesive composition according to any one of claims 1 to 3, wherein the polyorganosiloxane has a complex viscosity of 4,000 to 25,000 (Pa·S).

6. An adhesive composition according to any one of claims 1 to 5, wherein the adhesive component (S) contains a component (A) which is cured through hydrosilylation.

7. An adhesive composition according to claim 6,
wherein the component (A) which is cured through hydrosilylation comprises a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵ SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and
the polysiloxane (A1) comprises a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and a polyorganosiloxane (a2) having one or more units selected from the group consisting of a siloxane unit represented by SiO₂ (unit Q"), a siloxane unit represented by R^{1"}R^{2"}R^{3"}SiO_{1/2} (unit M"), a siloxane unit represented by R^{4"}R^{5"}SiO_{2/2} (unit D"), and a siloxane unit represented by R^{6"}SiO_{3/2} (unit T"), and at least one unit selected from the group consisting of unit M", unit D", and unit T" (wherein each of R^{1"} to R^{6"} is a group or an atom bonded to a silicon atom and represents an alkyl group or a hydrogen atom, and at least one of R^{1"} to R^{6"} is a hydrogen atom).

8. A laminate comprising a first substrate formed of a semiconductor-forming substrate, a second substrate formed of a support substrate, and an adhesive layer which binds the first substrate to the second substrate in a peelable manner,
wherein the adhesive layer is a film formed from an adhesive composition as recited in any one of claims 1 to 7.

9. A method for producing a laminate, the method comprising a step of applying an adhesive composition as recited in any one of claims 1 to 7 onto a first substrate formed of a semiconductor-forming substrate or a second substrate formed of a support substrate, to thereby form an adhesive coating layer; and
a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.

10. A method for debonding a laminate, the method comprising a step of applying an adhesive composition as recited in any one of claims 1 to 7 onto a first substrate formed of a semiconductor-forming substrate or a second substrate formed of a support substrate, to thereby form an adhesive coating layer;
a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment, to thereby produce a laminate; and
a second step of debonding the laminate at the interface between the first substrate and the adhesive layer.

11. A method for processing a semiconductor-forming substrate, the method comprising
a step of applying an adhesive composition as recited in any one of claims 1 to 7 onto a first substrate formed of a semiconductor-forming substrate or a second substrate formed of a support substrate, to thereby form an adhesive coating layer;
a step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment, to thereby produce a laminate; and
a step of processing the first substrate of the laminate.
